## Europäisches Patentamt
## European Patent Office
### Office européen des brevets

(11) Publication number: **0 096 752**
**B1**

(12) **EUROPEAN PATENT SPECIFICATION**

(45) Date of publication of patent specification: **03.12.86**

(51) Int. Cl.⁴: **H 03 K 5/24, H 03 M 1/38**

(21) Application number: **83104641.2**

(22) Date of filing: **06.03.80**

(60) Publication number of the earlier application in accordance with Art. 76 EPC: **0 015 554**

(54) Analog to digital converter circuit.

(30) Priority: **06.03.79 JP 25864/79**

(43) Date of publication of application:
**28.12.83 Bulletin 83/52**

(45) Publication of the grant of the patent:
**03.12.86 Bulletin 86/49**

(84) Designated Contracting States:
**DE FR GB**

(56) References cited:
**US-A-3 577 194**
**US-A-3 811 125**
**US-A-4 083 043**
**US-A-4 114 149**

**24TH ELECTRONIC COMPONENTS
CONFERENCE, 13-15 May 1974, Washington
R.A. CALKINS et al. "A microelectronic analog
to digital converter", pages 274-278 * Figures 2,
4 ***

(73) Proprietor: **NEC CORPORATION**
**33-1, Shiba 5-chome, Minato-ku**
**Tokyo 108 (JP)**

(72) Inventor: **Hareyama, Kyuichi**
**Nippon Electric Co., Ltd. 33-1, Shiba Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

## Description

The present invention relates to an analog to digital converter circuit, especially to an analog to digital converter circuit which is suitable for being used with a comparator circuit. Analog to digital circuits have been widely utilized in a form of monolithic integrated circuits. U.S. patent specifications 4 083 043 and 4 114 149 disclose this type of analog to digital converters. More specifically, the references disclose an analog to digital converter circuit comprising first means for receiving an analog signal, second means for producing a plurality of weighted reference signals, third means for selectively combining said reference signals to produce a combined signal, fourth means for obtaining difference in value between said analog signal and said combined signal, a differential amplifier having a first input terminal supplied with a potential having a value corresponding to said difference and a second input terminal supplied with a fixed potential, and control means responsive to an output of said differential amplifier for controlling said third means so as to reduce the value of the difference.

It is an object of the present invention to provide an analog to digital converter operable with high speed.

The invention is characterized in that said fourth means includes a first current mirror circuit having an input terminal and an output terminal, input means responsive to said analog signal for applying an analog current having a value proportional to said analog signal to said input terminal of said first current mirror circuit, a second current mirror circuit having an input terminal and an output terminal, means for connnecting the output terminal of said first current mirror circuit to the input terminal of said second current mirror circuit, and means for applying said combined signal to the output terminal of said second current mirror circuit.

In a preferred embodiment of the invention, said second means inlcudes a resistor ladder circuit.

The abovementioned and other features and objects of the present invention will become more apparent by reference to the following description of preferred embodiments of this invention taken in conjunction with the accompanying drawings, wherein:

Fig. 1 is a block diagram showing an A/D converter according to the present invention;

Fig. 2 is a wave from diagram for illustrating operation of logic section of Fig. 1; and

Fig. 3 is a wave form diagram showing conversion operation of the converter of Fig. 1.

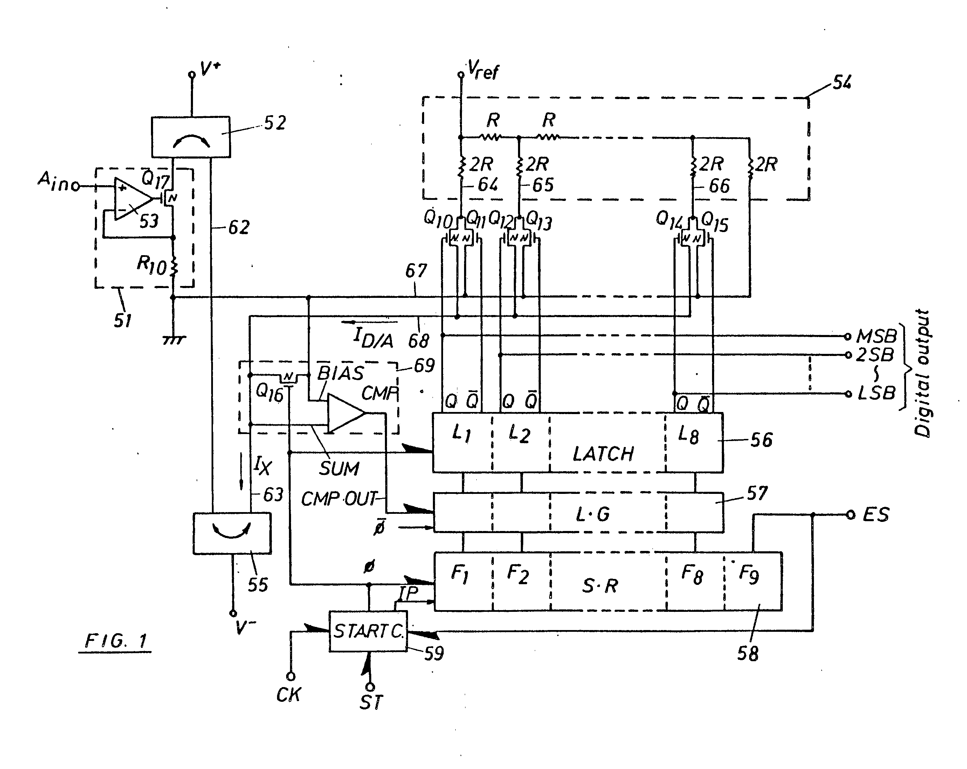

With reference to Figs. 1 to 3, one preferred application example of the present invention will be described. In this example, a comparator is combined with an A/D converter.

In Fig. 1, major parts of the A/D converter comprise a voltage-current converter circuit 51, current mirror circuits 52, 55, a resistor ladder circuit 54, a comparator circuit 69, latch circuits $L_1$ to $L_8$, a logic gate circuit 57 and a shift register 58. The voltage-current converter circuit 51 includes a differential amplifier 53, an N-channel FET $Q_{17}$ and a resistor $R_{10}$ and responds to a value of analog input voltage applied to a terminal $A_{in}$ to produce a corresponding value of current at its output line. The current mirror circuit 52 receives at its input the amount of current produced by the voltage-current converter 51 to produce the same amount of current at its output line 62. The current mirror circuit 55 produces the same amount of current as that on the line 62 at its output line 63 thereby to invert the polarity of the current on the line 62. The resistor ladder circuit 54 produces a plurality of weighted values of current at lines 64 to 66 in known manner. N-channel FET's $Q_{11}$, $Q_{13}$,— and $Q_{15}$ are arranged between the lines 64, 65,—and 66 and a common line 67, respectively. N-channel FET's $Q_{10}$, $Q_{12}$, and $Q_{14}$ are arranged between the lines 64, 65,—and 66 and a current summing line 68. True outputs Q of the latch circuits $L_1$ to $L_8$ are applied to gates of FET's $Q_{10}$, $Q_{12}$,—$Q_{14}$ and drawn out as a most significant bit (MSB) to least significant bit (LSB) of digital outputs. Complement ouputs $\overline{Q}$ of the latch cirucits $L_1$ to $L_8$ are applied to gates of FET's $Q_{11}$, $Q_{13}$,—$Q_{15}$. The shift register 58 shifts its data in response to a clock pulse φ. Outputs of the logic gate 57 are enabled by a clock signal $\overline{φ}$ having a reversed phase relation to the signal φ. The latch circuits $L_1$ to $L_8$ are made in write state in response to the clock signal φ and hold their data. A start control circuit 59 produces the clock signals φ and $\overline{φ}$ and an initial pulse IP of a single shot in response to a start command ST. In the comparator circuit 69, a N-channel FET $Q_{16}$ which is connected between the inputs of a differential amplifier CMP is made conductive in response to the clock signal φ so that the potential difference at the differential inputs of the said differential amplifier CMP is deleted. In this example, current difference between the current $I_X$ on line 63 corresponding to the analog input voltage at the terminal $A_{in}$ and a combined current $I_{D/A}$ on the line 68 appears at a summing point SUM coupled to one input of the amplifier CMP.

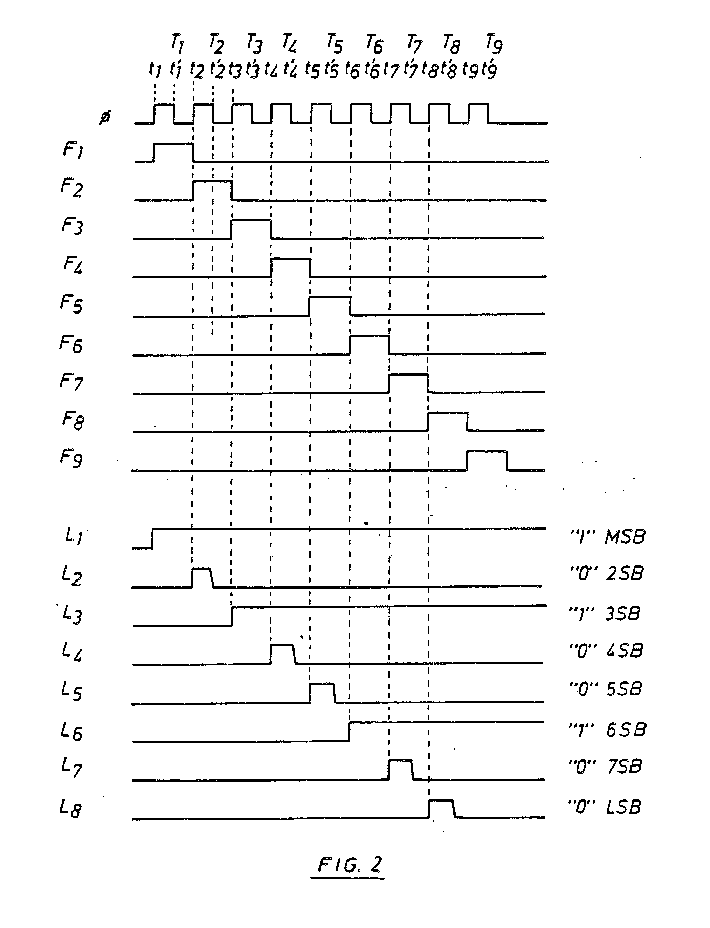

With reference to Fig. 2, operations of the major parts of Fig. 8 will be described.

In this figure, the same reference codes are used to show the wave forms of the corresponding parts. In response to the initial pulse and the clock signal φ, the shift register sequentially shifts the initial pulse from the stage $F_1$ to the stage $F_9$ in accordance with the cycle period of the clock pulse φ during time periods $T_1$ to $T_9$. The signal derived from the last stage $F_9$ is used as a conversion finish signal ES for resetting the star control circuit 59. Each of the outputs of the latch stages $F_1$ to $F_8$ are applied to the latch circuits $L_1$ to $L_8$ through the logic gate circuit 57 to sequentially preset the states of the latch circuit $L_1$ to $L_8$ in response to the high level of the clock signal.

During the first cycle period $T_1$, the transistor

$Q_{10}$ is made conductive in response to the high level of the output Q of the latch $L_1$, so that the most significant bit MSB is set. Therefore, the current $I_{D/A}$ is set to the current from the line 64 corresponding to MSB and is compared with the current $I_x$ corresponding to the input analog voltage by the comparator circuit 69 during the period from $t_1$ to $t_1'$. In this connection, each first half cycle period of the cycle period T, e.g. $t_1 - t_1'$, the transistor $Q_{16}$ is made conductive so that the differential input SUM of the amplifier is made substantially equal to the potential at the other inputs BIAS i.e. ground potential. Comparison result derived from the comparator circuit 69 is fed to the latch circuit $L_1$ through the logic gate circuit 57. The latch circuit $L_1$ latches the comparison result of the cycle period $T_1$ in response to a rise of the clock signal $\phi$ at a time point $t_2$ and holds it from the cycle period $T_2$. In Fig. 2, conversion result "10100100" is indicated as one example.

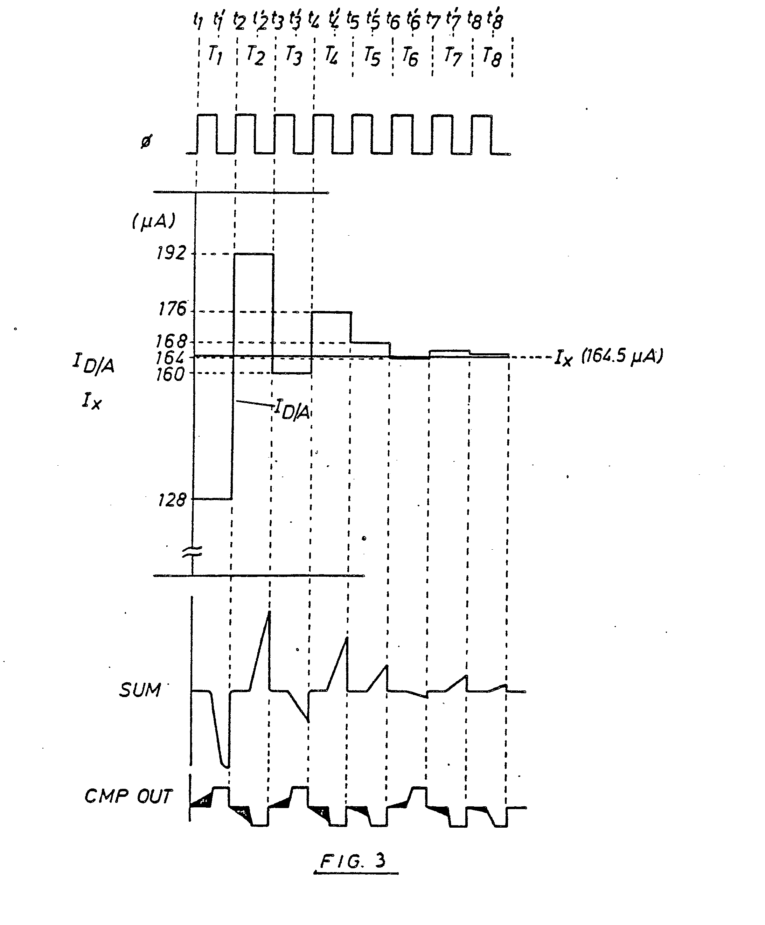

With reference to Fig. 3, one detailed operation of the circuit in Fig. 1 will be described. In the following description, it is assumed that full scale current of the D/A converter of Fig. 1 is 256 µA. At the cycle period $T_1$, the latch cirucit $L_1$ is set to establish MSB wherein the value of the current $I_{D/A}$ is 128 µA. Now, the current $I_x$ corresponding to the analog input is assumed to be 164.5 µA. Then, at second half cycle period i.e. the period of the low level of $\phi$ during the period $T_1$, the level of the summing point SUM is rapidly lowered based on a relation $I_{D/A} > I_x$ so that the output CMP OUT of the comparator circuit 69 changes to "1". The output CMP OUT of "1" is then latched by the latch circuit $L_1$ at rise of the signal $\phi$ ($t_2$) and the digital data MSB of "1" is established as one digit of the digital output. Then, at the succeeding period $T_2$, the second stage $F_2$ of the shift register 58 changes to "1" level and the transistor $Q_{12}$ is made conductive so that second significant bit of current at the line 65 is added to the current $I_{D/A}$. Therefore, the current $I_{D/A} = 128 + 64$ µA = 192 µA is produced at the line 68. In this case, there is provided a relation of $I_x < I_{D/A}$. Then, at the second half period $t_2' - t_3$, the current at the summing point SUM is rapidly increased so that the output CMP OUT changes to "0". This CMP OUT of "0" is latched by the latch circuit $L_2$. Thus, the second significant bit (2SB) is set at "0".

Then, similar operation is effected on the third significant bit (3SB) to the least significant bit (LSB) synchronous with the timing signal $\phi$. Through these comparison operations, there is a case in which the difference in value between the current $I_x$ and the $I_{D/A}$ becomes remarkably small. In the example of Fig. 3, during the period $T_6$, the difference between $I_x$ and $I_{D/A}$ takes a small value of 0.5 µA.

## Claims

1. An analog to digital converter circuit comprising first means ($A_{in}$) for receiving an analog signal, second means (54) for producing a plurality of weighted reference signals, third means ($Q_{10}$ to $Q_{15}$) for selectively combining said reference signals to produce a combined signal, fourth means (52, 55, 63, 68) for obtaining difference in value between said analog signal and said combined signal, a differential amplifier (CMP) having a first input terminal (SUM) supplied with a potential having a value corresponding to said difference and a second input terminal (BIAS) supplied with a fixed potential, and control means (56, 57, 58) responsive to an output of said differential amplifier for controlling said third means so as to reduce the value of the difference, characterized in that said fourth means includes a first current mirror circuit (52) having an input terminal and an output terminal, input means (53, $Q_{17}$, $R_{10}$) responsive to said analog signal for applying an analog current having a value proportional to said analog signal to said input terminal of said first current mirror circuit, a second current mirror circuit (55) having an input terminal and an output terminal, means (62) for connecting the output terminal of said first current mirror circuit to the input terminal of said second current mirror circuit, and means for applying said combined signal to the ouput terminal of said second current mirror circuit.

2. The circuit according to claim 1, characterized in that said second means includes a resistor ladder circuit (54).

## Patentansprüche

1. Analog/Digitalkonverterschaltung mit einer ersten Vorrichtung ($A_{in}$) zum Empfangen eines Analogsignals, einer zweiten Vorrichtung (54) zum Erzeugen einer Vielzahl von gewichteten Bezugssignale, einer dritten Vorrichtung ($Q_{10}$ bis $Q_{15}$) zum wahlweisen Kombinieren der Bezugssignale zum Erzeugen eines kombinierten Signals, einer vierten Vorrichtung (52, 55, 63, 68) zum Gewinnen eines Unterschieds im Wert zwischen dem Analogsignal und dem kombinierten Signal, einem Differentialverstärker (CMP) mit einem ersten Eingangsanschluß (SUM), der mit einem Potential versorgt wird, welches einen Wert hat, der dem Unterschied entspricht, und einem zweiten Eingangsanschluß (BIAS), welcher mit einem Festpotential versorgt wird, und einer Steuervorrichtung (56, 57, 58), die in Abhängigkeit vom Ausgangssignal des Differentialverstärkers die dritte Vorrichtung so steuert, daß der Wert der Differenz reduziert wird, dadurch gekennzeichnet, daß die vierte Vorrichtung eine Stromspiegelschaltung (52) aufweist mit einem Eingangsanschluß und einem Ausgangsanschluß, eine Eingangsvorrichtung (53, $Q_{17}$, $R_{10}$), welche in Abhängigkeit vom Analogsignal einen Analogstrom mit einem Wert proportional zum Analogsignal zum ersten Eingangsanschluß der ersten Stromspiegelschaltung zuführt, eine zweite Stromspiegelschaltung (55) mit einem Eingangsanschluß und einem Ausgangsanschluß, eine Vorrichtung (62) zum Verbinden des Ausgangsanschlusses der ersten Stromspiegelschaltung mit dem Eingangsanschluß der zweiten Stromspiegelschlaltung und eine Vorrichtung zum Zuführen des kombinierten Signals zum Ausgangsanschluß der zweiten Stromspiegelschaltung.

2. Schaltung nach Anspruch 1, dadurch gekennzeichnet, daß die zweite Vorrichtung eine Widerstandsleiterschaltung (54) enthält.

**Revendications**

1. Circuit de convertisseur analogique - numérique comprenant un premier moyen ($A_{In}$) pour recevoir un signal analogique, un second moyen (54) pour produire une pluralité de signaux de référence pondérés, un troisième moyen ($Q_{10}$ à $Q_{15}$) pour combiner sélectivement les signaux de référence afin de produire un signal combiné, un quatrième moyen (52, 55, 63, 68) pour obtenir une différence de valeur entre le signal analogique et le signal combiné, un amplificateur différentiel (CMP) ayant une première borne d'entrée (SUM) alimentée avec un potentiel ayant une valeur correspondant à ladite différence et une seconde borne d'entrée (BIAS) alimentée avec un potentiel fixe, et un moyen de commande (56, 57, 58) sensible à une sortie de l'amplificateur différentiel pour commander le troisième moyen de manière à réduire la valeur de la différence, caractérisé en ce que le quatrième moyen comprend un premier circuit de courant en rapport géométrique (52) ayant une borne d'entrée et une borne de sortie, un moyen d'entrée (53, $Q_{17}$, $R_{10}$) sensible au signal analogique, pour appliquer un courant analogique ayant une valeur proportionnelle au signal analogique à la borne d'entrée du premier circuit à courant en rapport géométrique, un second circuit à courant en rapport géométrique (55) ayant une borne d'entrée et une borne de sortie, un moyen (62) pour connecter la borne de sortie du premier circuit à courant en rapport géométrique à la borne d'entrée du second circuit à courant en rapport géométrique, et un moyen pour appliquer le signal combiné à la borne de sortie du second circuit à courant en rapport géométrique.

2. Circuit selon la revendication 1, caractérisé en ce que le second moyen comporte un circuit de résistances en échelle (54).

FIG. 1

0 096 752

FIG. 2

2

F I G. 3